# EUROPEAN PATENT APPLICATION

(11) **EP 4 694 581 A1**
(43) Date of publication of application: **11.02.2026**
(21) Application number: 24192921.5
(22) Date of filing: 05.08.2024
(51) Int. Cl.: H05K 1/02, H02M 7/00, B25J 5/02

(54) **ELECTRICAL CIRCUIT ARRANGEMENT**

(71) Applicant: AutoStore Technology AS, 5578 Nedre Vats (NO)
(72) Inventor: Aleksandersen, Rune Maberg, 5578 Nedre Vats (NO)
(74) Representative: Kilburn & Strode LLP

(57) **Abstract**

The disclosure relates to an arrangement of an electrical circuit for powering one or more phase windings of an electrical machine of an automated storage and retrieval system, and such a system and a vehicle for such a system which incorporate such an arrangement. The arrangement comprises: a plurality of layers 910 of the electrical circuit, interposed with electrically insulating material 920, wherein through-connections 930 are provided between the layers; and for each of the phase windings, a first set of electrical connections for mounting a first active device, a second set of electrical connections for mounting a second active device, and a connection point for electrical connection with the respective phase winding of the electrical machine; wherein for each of the phase windings there is provided a respective area of conductive material in at least one of the layers that forms at least a part of an electrical connection between the respective connection point and a respective supply terminal of the first active device and a respective receiving terminal of the second active device, wherein the respective supply terminal and the respective receiving terminal are electrically connected with their respective area by one or more of the through-connections 930 and without using signal traces for that connection.

## Description

### TECHNICAL FIELD

The present disclosure relates to an arrangement of an electrical circuit for powering one or more phase windings of an electrical machine of an automated storage and retrieval system, and such a system and a vehicle for such a system which incorporate such an arrangement.

### BACKGROUND

Traditional storage solutions usually involve the arrangement of goods on rows of shelves within a warehouse. The shelf location for each item is recorded in an inventory, and goods are retrieved from the shelves by a stock picker. The shelves are restocked and the inventory updated, as needed, as goods enter and leave the warehouse.

Warehouse workers may be assisted by robotic pickers and by automated inventory management systems. Automated transit systems may also be implemented in traditional warehouse set-ups to move goods from their inventory location to a picking and/or packing station.

An alternative to a traditional warehouse set-up is an automated storage and retrieval system in which robots retrieve items from their logged location within the warehouse and deliver the items to a packing station or port. Such systems can reduce or eliminate the space needed to pass between rows of shelves to access stock, thereby removing the need for broad aisles within the warehouse. One example of such a system involves placing goods in bins or containers that are configured to be stacked, side by side, within a three-dimensional grid of structural members amongst which a plurality of storage spaces are provided for storing a plurality of storage containers. In such an example, a rail system is arranged on top of the grid, along which robotic container-handling vehicles configured to lift containers from the grid can travel. The container-handling vehicles are configured to transport containers from the grid and to deliver them to ports or stations at the periphery of the grid so that the goods within the container can be picked and packed.

A problem with existing implementations of such an automated storage and retrieval system is that of how to provide electrical machines for motorisation of certain mechanisms such as container-handling vehicles and/or packing stations (or "ports"), wherein such electrical machines must be as compact, efficient and reliable as possible. Existing electrical machines have not proved entirely satisfactory, therefore the present application aims to at least partially address such problems.

### SUMMARY

Aspects and embodiments of the disclosure will now be summarised in the statements below, and one or more aspects of an invention of the present application are set out in the claims.

In a first aspect there is provided an arrangement of an electrical circuit for powering one or more phase windings of an electrical machine of an automated storage and retrieval system, the arrangement comprising:
a plurality of layers, each layer comprising a respective pattern of electrically conductive material constituting at least part of the electrical circuit, wherein the layers are interposed with electrically insulating material, and wherein through-connections are provided between the layers through the electrically insulating material to electrically combine the layers and thereby provide the electrical circuit; and
for each of the phase windings,
   a first set of electrical connections for mounting a first active device, the first set of electrical connections comprising (i) a power terminal for receiving current from a power supply to the first active device and (ii) a supply terminal for supplying current to the respective phase winding from the first active device,
   a second set of electrical connections for mounting a second active device, the second set of electrical connections comprising (iii) a receiving terminal for receiving current from the respective phase winding to the second active device and (iv) a ground terminal for sinking current to an electrical ground from the second active device, and
   a connection point arranged for electrical connection with the respective phase winding of the electrical machine;
wherein for each of the phase windings there is provided a respective area of conductive material in at least one of the layers, which area forms at least a part of an electrical connection between the respective connection point and the respective supply terminal and the respective receiving terminal, and
wherein the respective supply terminal and the respective receiving terminal are electrically connected with their respective area by one or more of the through-connections and without using signal traces for that connection.

Optionally, each supply terminal and/or receiving terminal is provided with at least one of the through-connections within the boundary of the respective terminal, for electrically connecting the respective terminal with its respective area of conductive material.

Optionally, each respective area of conductive material provided for the phase windings is on an inner layer between outer layers of conductive material connected to an electrical ground.

Optionally, the respective power terminals and/or the respective ground terminals are provided with a plurality of the through-connections.

Optionally, at least one of the plurality of layers comprises at least part of a power plane that is connected to the power supply for supplying power to the respective power terminals. Optionally, the respective power terminals are provided with a plurality of the through-connections within the boundary of the respective power terminal for electrically connecting the respective power terminal with the at least part of the power plane.

Optionally, at least one of the plurality of layers comprises at least part of a ground plane that is connected to electrical ground for sinking current from the respective ground terminals. Optionally, the respective ground terminals are provided with a plurality of the through-connections within the boundary of the respective ground terminal for electrically connecting the respective ground terminal with the at least part of the ground plane.

Optionally, a plurality of the layers are substantially filled with conductive material that is connected to electrical ground. Optionally, at least one of the layers that are substantially filled with conductive material that is connected to electrical ground is arranged as an outermost layer of the plurality of layers. Optionally, both of the outermost ones of the plurality of layers are ones of the layers that are substantially filled with conductive material that is connected to electrical ground. Optionally, each of the layers that are substantially filled with conductive material that is connected to electrical ground are interconnected by a plurality of the through-connections.

Optionally, at least one of the plurality of layers is provided for carrying low-current control signals, including signals for controlling one or more of the active devices. Optionally, a layer that is electrically connected to electrical ground is interposed between the at least one layer that is provided for carrying low-current control signals and layers that carry electrical current between the active devices and the connection points for electrical connection with the phase windings.

Optionally, the order or reverse order of layers includes: a succession of layers that are each associated with successive ones of the phase windings, followed by a layer substantially filled with electrically conductive material that is connected to electrical ground, and optionally then repeating the succession of layers that are each associated with successive ones of the phase windings, followed by another layer substantially filled with electrically conductive material that is connected to electrical ground.

Optionally, the number of phases is three, and wherein the order or reverse order of layers includes: a succession of layers that are each associated with successive ones of the phase windings, followed by a repeat of the succession of layers, followed by a layer substantially filled with electrically conductive material that is connected to electrical ground.

Optionally, the first and/or second active devices are mounted to the arrangement by way of the first and second sets of electrical connections.

Optionally, the first and second sets of electrical connections are surface mount solder pads, and the first and/or second active devices are mounted on an outer one of the layers by surface-mount solder connections to the first and second sets of electrical connections.

Optionally, the first and second sets of electrical connections are through-hole component mounting holes, and the first and/or second active devices are mounted through the arrangement. Optionally, the first and second sets of electrical connections constitute at least one of the through-hole connections with which the respective supply terminal and the respective receiving terminal are electrically connected with their respective area.

Optionally, the respective area for each of the phase windings is provided in a layer that is separate from that of the respective areas for the other phase windings.

Optionally, each respective area is a substantially unbroken area of conductive material.

Optionally, the respective connection point for each phase winding is located as near as possible to its corresponding supply terminal and receiving terminal.

Optionally, a connector comprising respective connections for each of the phase windings is mounted to the connection points, and the connector is located proximate to the first and second active devices.

Optionally, each layer is substantially filled with electrically conductive material.

Optionally, the conductive material is a metal, namely one of copper, aluminium, silver or gold, an alloy of said metals, or one of said metals electroplated with another of said metals.

Optionally, the arrangement is a multi-layer printed circuit board, and wherein the through-connections are printed circuit board vias and/or through-hole component mounting holes.

Optionally, the arrangement further comprises the first and second active devices.

Optionally, a plurality of first active devices are provided per phase and a plurality of second active devices are provided per phase, and optionally wherein the number of first active devices per phase equals the number of second active devices per phase.

Optionally, the active devices are transistors, and optionally are field effect transistors.

Optionally, there are three motor phase windings.

In a second aspect there is provided an automated storage and retrieval system comprising a grid of structural members amongst which a plurality of storage spaces are provided for storing a plurality of storage containers, said automated storage and retrieval system further comprising at least one component having one or more electrical machines powered by an arrangement according to the first aspect, wherein each at least one component is a vehicle and/or a packing station, and optionally wherein the vehicle is (i) a container handling vehicle provided for lifting, lowering and transporting storage containers or (ii) a service vehicle for assisting with maintenance operations on the grid.

In a third aspect there is provided a vehicle for an automated storage and retrieval system according to the second aspect, wherein the vehicle comprises one or more electrical machines powered by an arrangement according to the first aspect. Optionally, the vehicle is (i) a container handling vehicle provided for lifting, lowering and transporting storage containers or (ii) a service vehicle for assisting with maintenance operations on the grid.

In a fourth aspect there is provided an electrical machine for an automated storage and retrieval system, said electrical machine having integrated therein an arrangement according to the first aspect.

In the following description, various specific details are introduced by way of example only, to provide for enhanced understanding of embodiments of the claimed system and method. One skilled in the relevant art, however, will understand from this disclosure that these embodiments can be practiced without one or more of the specific details, or with other components, systems, etc. in any combination except where technically incompatible. In other instances, certain existing details are at least partially omitted for clarity purposes, but nevertheless the skilled person will have no difficulty in reproducing the disclosed aspects in the light of this disclosure.

### BRIEF DESCRIPTION OF THE DRAWINGS

The disclosure will now be described in more detail in connection with a number of exemplary embodiments shown in the accompanying drawings, in which:
Fig. 1 shows a perspective view of a storage system comprising a grid and a plurality of robotic container-handling vehicles configured to retrieve and/or rearrange goods stored within the grid;
Fig. 2 shows a top view of the system of Fig. 1;
Fig. 3a shows a side view of a first robotic container-handling vehicle suitable for use in the system of Fig. 1;
Fig. 3b shows a side view of a second robotic container-handling vehicle suitable for use in the system of Fig. 1;
Fig. 3c is a perspective side view of the robot of Fig. 3b;
Fig. 4 shows a computing device for implementing the operations described herein;
Fig. 5 shows components of a container-handling vehicle such as that shown in Fig. 3a, including electrical machines in the form of electric motors.
Fig. 6 is an example schematic diagram of an electrical circuit for powering phase windings of an electrical machine such as an electric motor.
Fig. 7 is a view of a conventional arrangement of the electrical circuit as in Fig. 6.
Fig. 8 is a view of a top of an arrangement of an electrical circuit such as that of Fig. 6, in accordance with embodiments of the present disclosure.
Fig. 9 is a side view through a cross-section of an arrangement such as that of Fig. 8.
Fig. 10 shows an example layer stack of an arrangement such as that of Fig. 8.
Fig. 11 is a view of a top layer of an arrangement such as that of Fig. 8.
Fig. 12 is a view of a ground layer of an arrangement such as that of Fig. 8.
Fig. 13 is a view of a first inner layer (for a first phase winding) of an arrangement such as that of Fig. 8.
Fig. 14 is a view of a second inner layer (for a second phase winding) of an arrangement such as that of Fig. 8.
Fig. 15 is a view of a third inner layer (for a third phase winding) of an arrangement such as that of Fig. 8.
Fig. 16 is a view of a bottom layer of an arrangement such as that of Fig. 8.

In the drawings, like reference numerals have been used to indicate like parts, elements or features unless otherwise explicitly stated or implicitly understood from the context.

### DETAILED DESCRIPTION

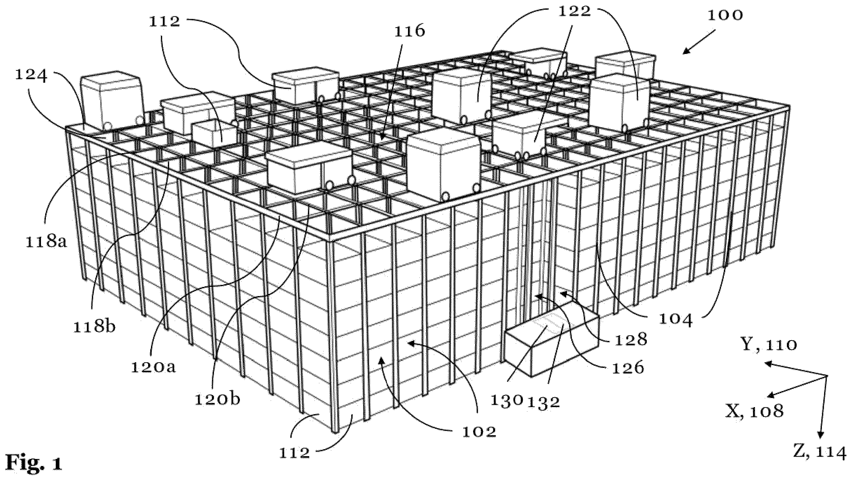

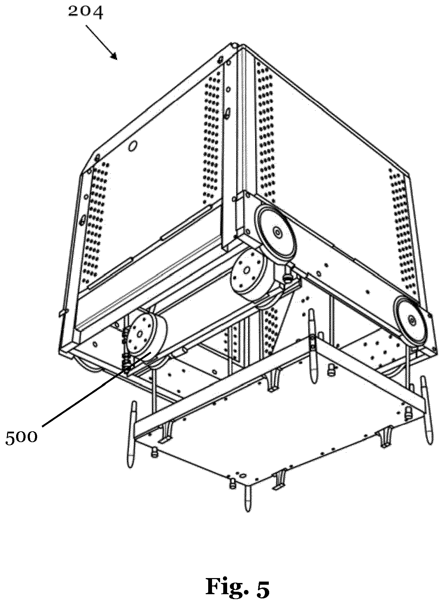

In overview, a need exists in automated storage and retrieval systems (of the type described herein with reference to Figs. 1 to 5) for compact electrical machines, e.g. electric motors (brushless or brushed). Such machines (hereafter referred to as motors, for brevity) need to be efficient, reliable, and compact. The inventors have realised that part of the reliability constraint is that as well as the motors needing to operate reliably in themselves, they also need to operate in a manner which lends reliability to other components in the system. For example, vehicles which operate in the system, such as container handling "robots" and service vehicles, are constrained in size because they must operate within the boundaries of storage cell dimensions, and thus the amount of space inside such vehicles for housing motors (and associated drive electronics for powering the motors) is limited. This means that components inside the vehicles are typically packed closely together, and so cooling can be problematic, and also electromagnetic compatibility can be difficult to achieve (since the closer that components and interconnections are to other such components and interconnections, the greater the chance of electromagnetic interference being radiated from one component into another component, potentially causing incorrect operation and/or failure of a controller. Similar constraints and effects also apply in the use of motors in the other motorised components of such an automated storage and retrieval system, for example in the motorised picking "ports" that are used by operators to load and unload containers into and out of the storage "grid" which holds stacks of containers.

Given the need (which the inventors have realised exists) for high electromagnetic compatibility from motors and their associated drive electronics, the presently disclosed arrangement of an electrical circuit (for powering one or more phase windings of an electrical machine) has been arrived at by the inventors.

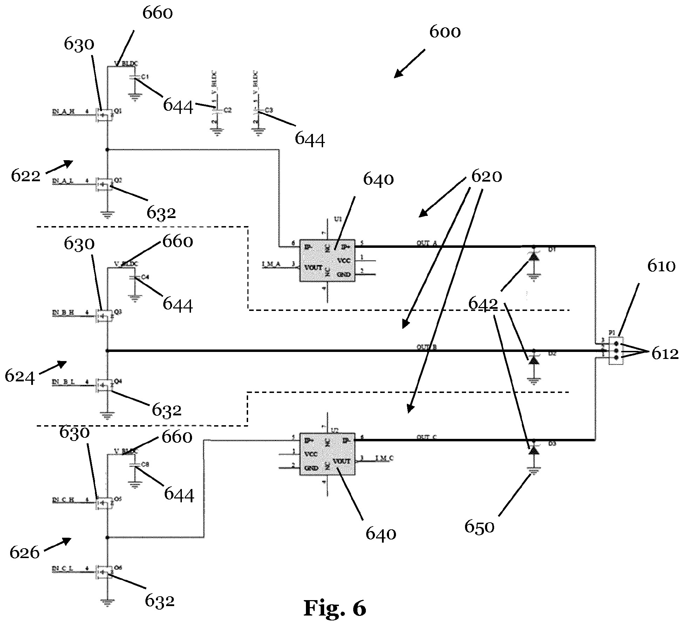

As known in the art, a typical motor has three stator windings that are connected in a star configuration and in use are energised in sequence by an electronic circuit that powers the motor by driving current into one winding and pulling the current out of another winding. Such a circuit is shown in Fig. 6, and comprises three "phase" sections 622, 624 and 626. Each phase has a pair of active devices 630, 632 (which can for example be transistors, such as Field Effect Transistors or Bipolar Junction Transistors, or any other type of transistor), connected in a push-pull configuration to drive current out of, or sink current in from, a corresponding connection point 612. More specifically, each pair includes a first active device 630 which can receive current from a power supply 660 via a power terminal (e.g. collector or drain) and supply the current to the phase winding via a supply terminal (e.g. emitter or source). Each pair also includes a second active device 632 which can receive current from the phase winding via a receiving terminal (e.g. collector or drain), and sink the current to an electrical ground 650 via a ground terminal (e.g. emitter or source). In the given example, the three connection points 612 are comprised in or connect to a connector 610 for connecting to the phase windings of said motor, however the connector can be omitted and instead wires can be directly soldered or crimped.

A greater or smaller number of phases than 3 can be used. Other components shown in Fig. 6 include: freewheel diodes 642 which limit negative voltages that are induced by the inductance of the motor coils when the active devices shut off current flow, and thereby protect the active devices 630, 632; reservoir/decoupling capacitors 644 which stabilise the power rails that feed the active devices 630, 632; and Hall effect current sensors 640 which are required on phases 1 and 3 only to detect the amount of current flowing for purposes of field-oriented feedback control regulation, and which can otherwise be considered to be equivalent to a piece of wire linking the junction between the first and second active devices 630, 632 and the connection point 612.

By way of example, in operation: in a first driving step the circuit drives current into the first phase winding and sinks current out of the second phase winding; in a second driving step the circuit drives current into the second phase winding and sinks current out of the third phase winding; in a third driving step the circuit drives current into the third phase winding and sinks current out of the first phase winding. It will be noted that the transition between each driving step entails quickly reversing the current in the phase winding that is common between one driving step and the next driving step. The rate of change of current can be high, especially for higher motor speeds, and can result in high levels of radiated emissions due to interaction with inductance of circuit segments through which the current flows. Such emissions can cause certification tests to be failed, and furthermore can cause incorrect operation of a vehicle or other unit comprising such a motor and motor driving electronics, e.g. due to radiated emissions being picked up by adjacent cabling that may be carrying control signals and/or data, thereby resulting in control or sensing data errors which can cause such incorrect operation.

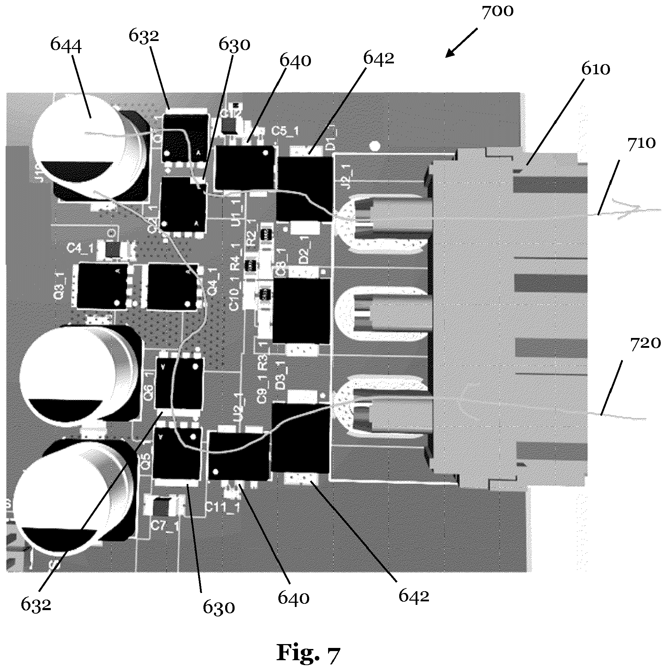

It has been realised by the inventors that a major source of the above-mentioned emissions in conventional arrangements 700 of such a circuit, such as that shown in Fig. 7, is that phase winding currents typically flow in surface conductors that are constrained (e.g. by placement of components) to be relatively narrow compared to their lengths (in the centimetre range) due to lack of space caused in part by the presence of component mounting terminals (or "pads"), thereby leading to significant inductance which, when large current swings occur in said conductors, results in significant radiation of electromagnetic energy by the conductors acting as a radiating antenna e.g. during pulse width modulation of the active devices (e.g. MOSFETs). For example, Fig. 7 shows a current supply path 710 feeding a first phase winding (from a power supply 660, through first active device 632 and current sensor 640), and a current return path 720 sinking current from a third phase winding (through current sensor 640 and second active device 632 to ground). The resulting inductance, coupled with a lack of shielding covering the conductor, results in poor electromagnetic compatibility performance. Such arrangements are traditionally used to aid cooling to the transistors, in which case electromagnetic interference is typically not considered - instead, cost of circuit board production is often a major driver such that boards with fewer layers are favoured. Additionally, control logic often has to be placed on a separate board so that thicker copper layers can be used on the motor driver board (thicker copper cannot be etched to such fine detail, hence the complicated control logic board often has to be separately implemented due to it having many thin and densely packed circuit traces).

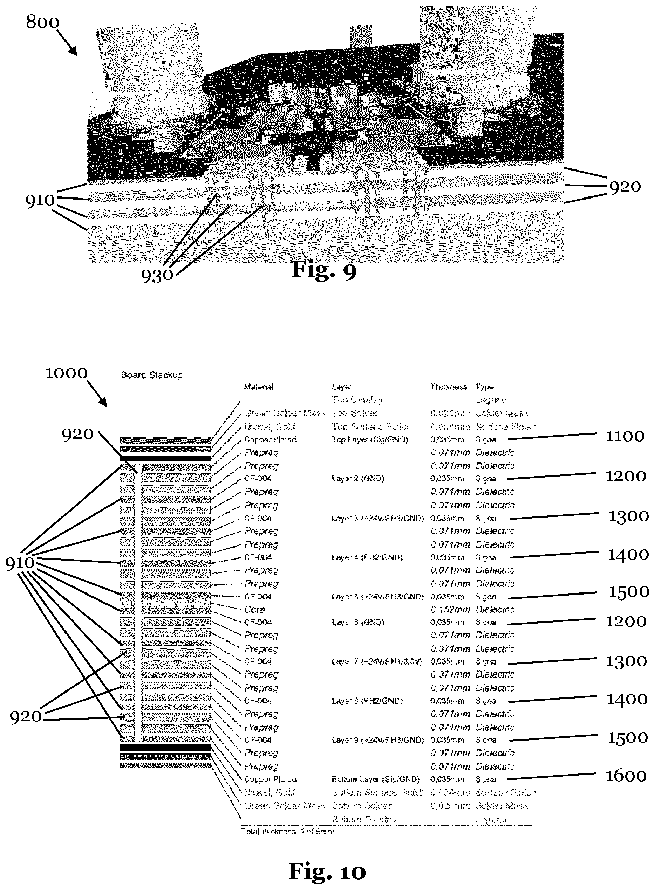

By way of a brief outline (which will be later discussed in more detail), the present disclosure addresses the above deficiency by providing a new arrangement of the electrical circuit of Fig. 6, in which current flows vertically from/to the first/second active devices via through-connections 930 (e.g. printed circuit board vias) to/from an area of conductive material that connects the first and second active devices 630, 632 to a connection point 612 that is provided for connecting to a respective phase winding. As shown in Fig. 9, the through-connections 930 are preferably placed within a boundary of the component-mounting connections (e.g. printed circuit board "pads"). By virtue of the through-connections 930 it is implicit that the area of conductive material that connects the first/second active devices 630, 632 to the connection point 610 (henceforth referred to as "the area of conductive material" is in a different layer from that on which the component-mounting connections are provided. This arrangement is repeated for each of the phase windings.

An advantage of this arrangement is that because the area of conductive material is not on the same (e.g. outer) layer 910 as the component-mounting connections, there is more area available for a wide, and therefore low inductance, area of conductive material (e.g. copper, aluminium, gold, silver etc.). The resulting lowered inductance (and also resistance) reduces radiated emissions when the current flow in the conductor rapidly reverses during phase transitions while driving the electrical machine. Optionally, the area of conductive material is on an inner layer between outer layers of conductive material connected to an electrical ground, which grounded layers thereby provide a low impedance return path for any radiated electromagnetic signals and so prevent such signals from being radiated further, thereby reducing electromagnetic emissions. Due to the through-connections 930 being placed within the boundary of the component-mounting connections, virtually no current flows across the outer layers of the circuit arrangement (e.g. in a horizontal direction), all horizontal current flow instead being through wide, low impedance layers that are preferably inner layers and are shielded by grounded outer layers. Thus, emissions are greatly reduced compared to existing arrangements such as that shown in Fig. 7. The arrangement will be described in more detail below, after the following introduction to the automated storage and retrieval system in which embodiments typically operate.

### Automated storage and retrieval system overview

Referring to the embodiment shown in Fig. 1, a grid 100 comprises a frame formed by a plurality of generally rectilinear, adjacent vertical columns 102 (each vertical column 102 comprising a plurality of storage spaces for storing a plurality of storage containers in a vertical stack) formed between vertical frame members ("frame members" otherwise being termed "structural members") 104 and extending in the X and Y directions 108, 110. The grid elements (frame members) may be fabricated of any appropriate material; for example, the frame members may be formed of metal, such as extruded aluminium. Storage containers or bins 112 can be stacked on top of each other, preferably in a self-supporting manner, in the Z direction 114 in the columns 102, forming a storage volume of storage cells for respective bins 112 extending in the X, Y and Z directions 108, 110, 114.

A rail system or network 116 is formed on top of the grid 100 and comprises pairs of vehicle rails or tracks 118a, 118b and 120a, 120b, respectively extending in the X and Y directions 108, 110. For example, a first set of parallel tracks comprises multiple pairs of vehicle rails or tracks 118a, 118b extending in a first grid direction (X direction 108), and a second set of parallel tracks comprises multiple pairs of vehicle rails or tracks 120a, 120b extending in a second grid direction (Y direction 110) that is angularly offset from the first grid direction, e.g. orthogonal to it. Robotic container-handling vehicles, or robots, 122, which can be of a range of size, shape and function, are provided and configured to run on the rails 118, 120 and to transport bins 112 in both the X and Y directions 108, 110. The robots 122 are additionally configured to lift and lower bins 112 from/into the columns 102 in the Z direction 114, the bins 112 optionally being guided by the vertical frame members 104. The robots 122 access the bins 112 via access openings 124 above the columns 102 and formed between the rails 118, 120. A plurality of corresponding horizontal structural members can be included to support the first and second sets of parallel tracks in a substantially horizontal plane.

Some columns 102 may be used for alternative purposes than bin storage. For example, port columns 126, 128 comprise port or access columns allowing transfer of a bin 112 in and/or out of the grid 100. Port columns 126, 128 provide a vertical channel for lifting of a bin 112 from, or lowering of a bin 112 to, a port or ports 130, 132. The ports 130, 132 are shown in Fig. 1 at the lowest level of the grid, however ports can be located at any vertical position along the column. The respective port columns 126, 128 can be assigned for removing ('drop-off) and/or returning or delivering ('pick-up') bins 112 from/to the grid 100. The ports 130, 132 are therefore configured to allow bins 112 to be removed and reintroduced (horizontally) into the associated port column. As such, a port 130, 132 can comprise a conveyor (not shown in Fig. 1) onto which a bin 112 may be lowered and transported horizontally out of the port column. The port columns 126, 128 include an opening or access point through which bins 112 can enter and leave the column.

Bins 112 can be transported along the top of the grid 100 to and/or from a port column 126, 128 by robots 122, and from a port 130, 132 to a location outside the grid 100, which may be an access station (not shown) for processing of the bin 112 or its contents, such as a picking station for adding content to, or removing content from, the bin 112. In alternative examples (not shown), the bin 112 may be transported to a port of another grid on the same or another level, or to an external facility. Transport of bins 112 to and from ports 130, 132 may be by any appropriate means (not shown) including conveyors, transport vehicles, lifts or robots.

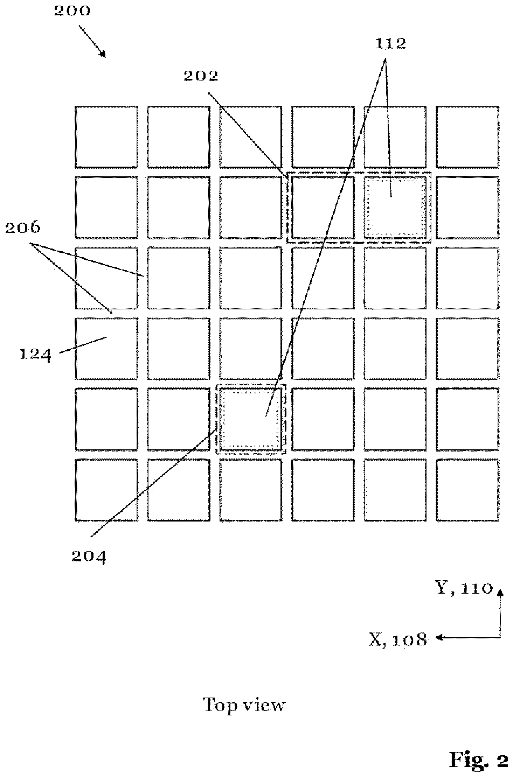

Referring to the embodiment shown in Fig. 2, the X-Y configuration 200 of the rail system 116 can be seen in more detail, together with robots 202, 204 of different types. The rail system includes rails 206 defining between them vertical column access openings 124 for access to bins 112. The rails 206 can be any appropriate type for permitting travel of the robots 202, 204 in the X and Y directions 108, 110 thereon, including (not shown) groove-type rails for receiving vehicle wheels, or protrusion-type rails for engaging wheel recesses. Each rail 206 may comprise a single track or multiple parallel tracks in each of the X and Y directions 108, 110.

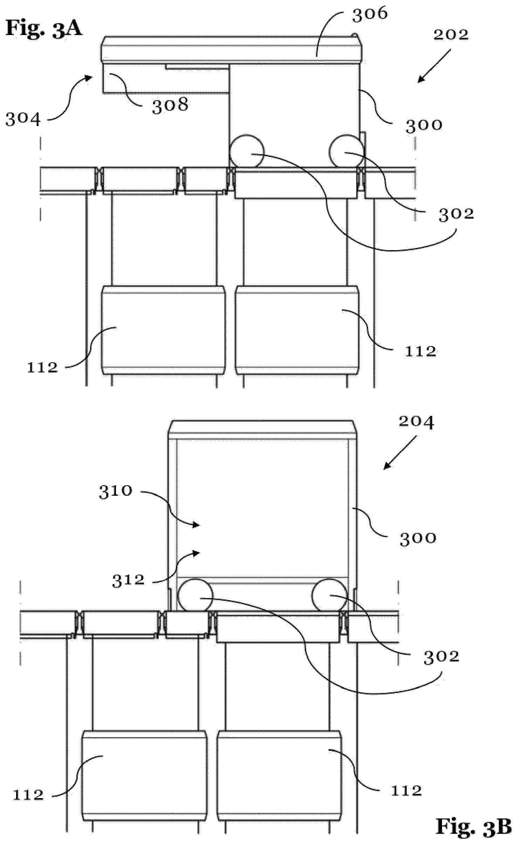

A first, 'cantilever' type of robot 202 is shown in more detail in Fig. 3A and includes a body 300, a set of wheels 302 and a lifting device 304. The body 300 contains operational equipment (not shown) for the robot 202 including drive, power and control systems. The wheels 302 permit movement of the robot 202 in one of the X and Y directions, an additional set of wheels (not visible in this view) permitting movement in the other of the X and Y directions, in both cases along the respective rails or tracks 206. One or both sets of wheels can be raised or lowered to permit selective engagement of the rails for movement in the desired direction. The lifting device 304 includes a cantilever element 306 extending in the X-Y plane from the top of the body 300, and a gripping device 308, which is raisable and lowerable from the cantilever element 306. The gripping device 308 is configured to grip or engage a bin 112; for example, by gripping a part of the bin 112, or by passively or actively engaging a suitably configured part of the bin 112.

A second, 'internal cavity' type of robot 204 is shown in more detail in Fig. 3B and includes, as an alternative to the cantilevered lifting system, an internal cavity 310 within the body 300 and in which the lifting device 312 including a gripping device (not shown) is located. In this case, the body 300 includes the robot's operational equipment and a storage space for one or more bins 112, for use, for example, while transporting the bin 112.

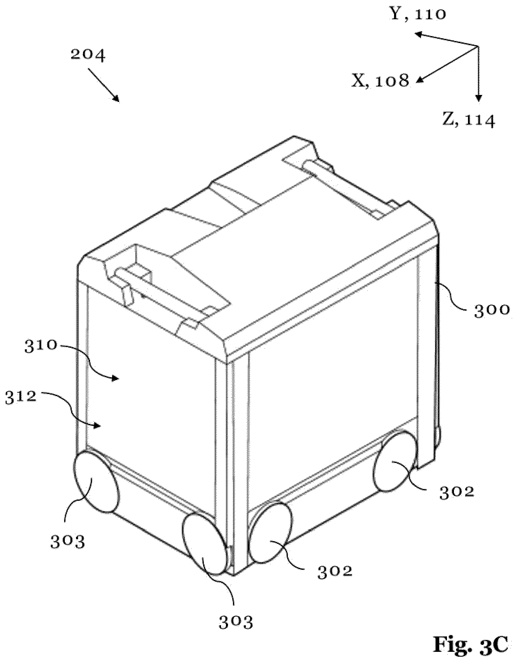

Fig. 3C shows a perspective side view of the robot of Fig. 3B in which the first set of wheels 302 from Fig. 3B are visible. The additional set of wheels referenced above but not shown in Fig. 3B are shown as wheels 303 in Fig. 3C. The additional set of wheels 303 is arranged perpendicular to the first set of wheels 302, to allow rolling of the robot 204 in the X and Y directions on the first and second set of wheels 302, 303 respectively. The first and second set of wheels 302, 303 shown in Fig. 3C may be configured to be independently lowered into engagement with the rails (and conversely raised out of engagement with the rails) to allow the robot 202 to move in the X and Y direction across the arrangement of rails shown in Fig. 2. Although the perspective view shown in Fig. 3C is of the robot 204 of Fig. 3B, it will be appreciated that a similar perpendicular wheel arrangement may be applied to the robot 202 of Fig. 3A.

### Control and monitoring system

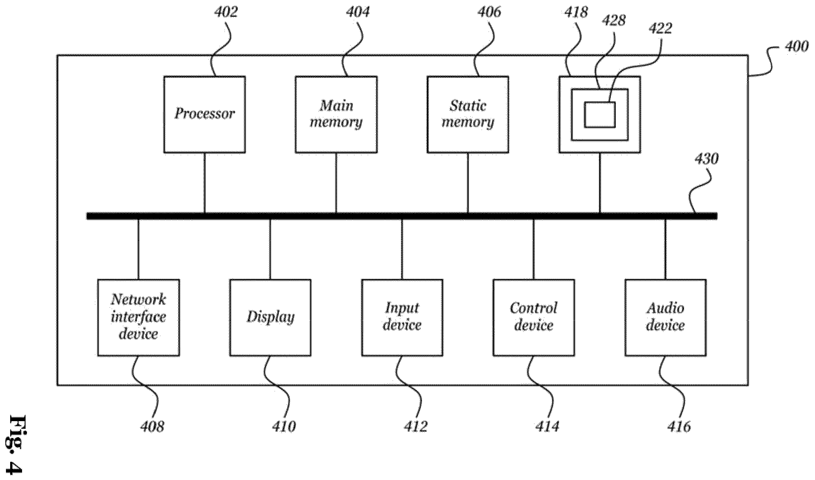

Control and monitoring of the automated storage and retrieval system, including monitoring and storing bin position and controlling bin delivery, retrieval and transport and robot routing and collision avoidance, is performed by a control system shown in Fig. 4 in communication with the robots and/or other controllable system components. Control can be performed locally or remotely and may be implemented by a processing system, for example in the form of a computing device. Accordingly, the methods described herein may form all or part of a computer-implemented method, or a system configured to perform the methods described herein.

With reference to Fig. 4, a processing system 400 suitable for carrying out the methods described herein will now be described. Fig. 4 shows a block diagram of one implementation of a processing system 400 in the form of a computing device within which a set of instructions for causing the computing device to perform any one or more of the methods described herein may be executed. In some implementations, the computing device may be connected (e.g., networked) to other machines in a Local Area Network (LAN), an intranet, an extranet, or the Internet. The computing device may operate in the capacity of a server or a client machine in a client-server network environment, or as a peer machine in a peer-to-peer (or distributed) network environment. The computing device may be a personal computer (PC), a tablet computer, a set-top box (STB), a Personal Digital Assistant (PDA), a cellular telephone, a web appliance, a server, a network router, switch or bridge, or any machine capable of executing a set of instructions (sequential or otherwise) that specify actions to be taken by that machine. Further, while only a single computing device is illustrated, the term 'computing device' shall also be taken to include any collection of machines (e.g., computers) that individually or jointly execute a set (or multiple sets) of instructions to perform any one or more of the methods described herein.

The example processing system 400 includes a processor 402, a main memory 404 (e.g., read-only memory (ROM), flash memory, dynamic random-access memory (DRAM) such as synchronous DRAM (SDRAM) or Rambus DRAM (RDRAM), etc.), a static memory 406 (e.g., flash memory, static random-access memory (SRAM), etc.), and a secondary memory (e.g., a data storage device 418), which communicate with each other via a bus 430.

Processor 402 represents one or more general-purpose processors such as a microprocessor, central processing unit, or the like. More particularly, the processor 402 may be a complex instruction set computing (CISC) microprocessor, reduced instruction set computing (RISC) microprocessor, very long instruction word (VLIW) microprocessor, processor implementing other instruction sets, or processors implementing a combination of instruction sets. Processor 402 may also be one or more special-purpose processors such as an application specific integrated circuit (ASIC), a field programmable gate array (FPGA), a digital signal processor (DSP), network processor, or the like. Processor 402 is configured to execute the processing logic (instructions 422) for performing the operations and steps described herein.

The processing system 400 may further include a network interface device 408. The processing system 400 also may include any of a video display unit 410 (e.g., a liquid crystal display (LCD) or a cathode ray tube (CRT)), an alphanumeric input device 412 (e.g., a keyboard or touchscreen), a cursor control device 414 (e.g., a mouse or touchscreen), and an audio device 416 (e.g., a speaker).

It will be apparent that some features of the processing system 400 shown in Fig. 4 may be absent. For example, the processing system 400 may have no need for display device 410 (or any associated adapters). This may be the case, for example, for particular server-side computer apparatuses which are used only for their processing capabilities and do not need to display information to users. Similarly, user input device 412 may not be required. In its simplest form, processing system 400 comprises processor 402 and main memory 404.

The data storage device 418 may include one or more machine-readable storage media (or more specifically one or more non-transitory computer-readable storage media) 428 on which is stored one or more sets of instructions 422 embodying any one or more of the methods or functions described herein. The instructions 422 may also reside, completely or at least partially, within the main memory 404 and/or within the processor 402 during execution thereof by the processing system 400, the main memory 404 and the processor 402 also constituting computer-readable storage media 428.

The various methods described herein may be implemented by a computer program. The computer program may include computer code arranged to instruct a computer to perform the functions of one or more of the various methods described herein. The computer program and/or the code for performing such methods may be provided to an apparatus, such as a computer, on one or more computer-readable media or, more generally, a computer program product. The computer-readable media may be transitory or non-transitory. The one or more computer-readable media could be, for example, an electronic, magnetic, optical, electromagnetic, infrared, or semiconductor system, or a propagation medium for data transmission, for example for downloading the code over the Internet. Alternatively, the one or more computer-readable media could take the form of one or more physical computer-readable media such as semiconductor or solid-state memory, magnetic tape, a removable computer diskette, a random-access memory (RAM), a read-only memory (ROM), a rigid magnetic disc, or an optical disk, such as a CD-ROM, CD-R/W or DVD.

The computer program is executable by the processor 402 to perform functions of the systems and methods described herein.

In an implementation, the modules, components, and other features described herein can be implemented as discrete components or integrated in the functionality of hardware components such as ASICS, FPGAs, DSPs, or similar devices.

A 'hardware component' is a tangible (e.g., non-transitory) physical component (e.g., a set of one or more processors) capable of performing certain operations and may be configured or arranged in a certain physical manner. A hardware component may include dedicated circuitry or logic that is permanently configured to perform certain operations. A hardware component may be or include a special-purpose processor, such as a field programmable gate array (FPGA) or an ASIC. A hardware component may also include programmable logic or circuitry that is temporarily configured by software to perform certain operations.

Accordingly, the phrase 'hardware component' should be understood to encompass a tangible entity that may be physically constructed, permanently configured (e.g., hardwired), or temporarily configured (e.g., programmed) to operate in a certain manner or to perform certain operations described herein.

In addition, the modules and components can be implemented as firmware or functional circuitry within hardware devices. Further, the modules and components can be implemented in any combination of hardware devices and software components, or only in software (e.g., code stored or otherwise embodied in a machine-readable medium or in a transmission medium).

### Operation of the automated storage and retrieval system

In operation, each bin 112 is given a unique identifier, which maybe marked on the bin 112 using a computer-readable identifier (e.g., a barcode, quick-response code or radio-frequency identification tag) to ease identification of the bin 112. A database of the processing system 400 stores, in association with the unique identifier, the position and, optionally, content of each bin 112. When a bin 112 is moved (e.g., when it is retrieved from the grid 100), the database is updated to record its change in position.

When it is desired to retrieve a bin 112 from the grid 100, under control of the processing system 400, a robot 202, 204 is routed via the rail system 116 to the vertical column 102 including the storage cell where, according to the database, the bin 112 is positioned, and the lifting device 304, 312 is positioned (according to robot type) over the corresponding access opening 124, either adjacent or below the robot 202, 204. The robot 202, 204 lowers the gripping device 308 which engages, grips and lifts the bin 112 to the robot 202, 204. The robot 202, 204 then transports the bin 112, for example, to the drop-off port column 126, 128 for delivery to the port 130, 132 and subsequent processing external to the grid 100. In the event that the target or designated bin 112 is below other bins in the stack then the robot 202, 204 or multiple robots, which may be dedicated to the task, are controlled in a 'digging' operation to sequentially lift and reposition, temporarily or permanently, bins above the target bin 112 in order for it to be retrieved. It will be appreciated that other operations in relation to the bin 112 can be carried out in a similar manner. For example, a bin 112 can be delivered for storage in the grid 100 at the port 130, 132 of the pick-up port column 126, 128, gripped and lifted by a robot 202, 204 and delivered to the desired storage cell, bins above the desired position being repositioned if necessary as discussed above.

### Description of specific improvements

In the following description of aspects and embodiments of the disclosure will be discussed with reference to the drawings. It will be appreciated that the described aspects, examples and embodiments are not intended to limit the scope of protection, the scope of protection being defined instead by the appended claims. It will also be appreciated that features of the disclosed aspects and embodiments can be combined with those of other aspects and embodiments wherever indications to the contrary are absent.

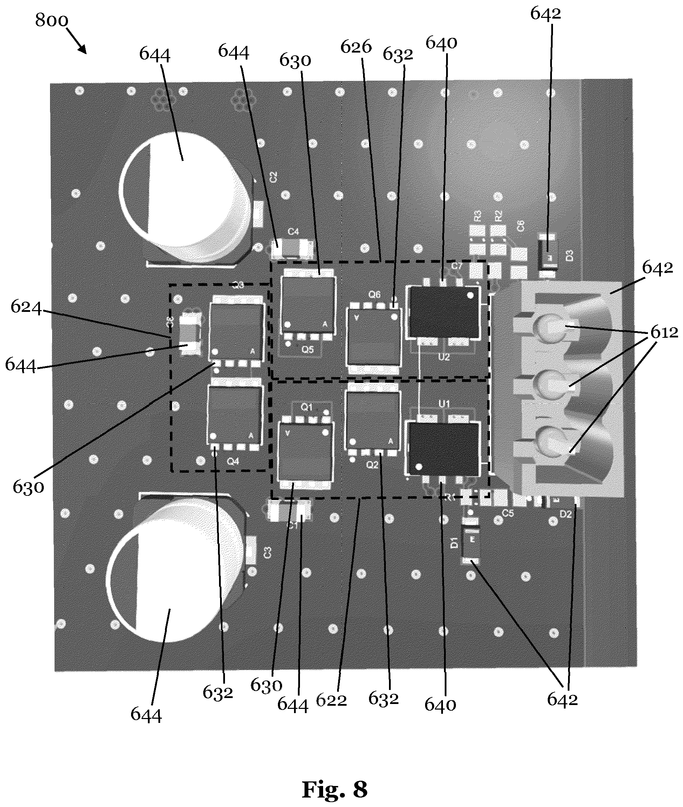

As outlined above, the present disclosure provides a new arrangement of the electrical circuit of Fig. 6, in which arrangement, current flows vertically from/to the first/second active devices via through-connections 930 (e.g. printed circuit board vias) to/from an area of conductive material that connects the first and second active devices 630, 632 to a connection point 612 that is provided for connecting to a respective phase winding. An advantage of this arrangement is that because the area of conductive material is implicitly not on the same (e.g. outer) layer 910 as the component-mounting connections (e.g. component-mounting pads), there is more area available for a wider, low inductance, connection formed from the area of conductive material, and this reduces radiated emissions. Preferably but optionally, the area of conductive material is on an inner layer between outer layers of conductive material that are connected to an electrical ground, thereby shielding the inner layers and further reducing electromagnetic emissions. The arrangement will now be described in more detail with reference to Figs. 6 and 8 to 16.

As shown in Figs. 6 and 8 to 10, an arrangement 800 of an electrical circuit 600 for powering one or more phase windings (e.g. 3 phase windings, although a greater or smaller number can be catered for by simply increasing/reducing the number of sections corresponding to phases 620 in Fig. 6) of an electrical machine 500 (such as a motor), such as an electrical machine 500 in an automated storage and retrieval system 100 described with reference to Figs. 1 to 5, is provided. The arrangement 800 comprises a plurality of layers 910 as shown in the cross-sectional view of Fig. 9, and the layer stack-up diagram of Fig. 10. Each layer 910 comprises a respective pattern of electrically conductive material (such as copper, aluminium, gold, or silver, or other conductive material having low resistance and reasonable mechanical compatibility with a suitable substrate such as glass fibre FR4 material or ceramic substrate) constituting at least part of the electrical circuit 600. For example, known printed circuit board constructions and hybrid module constructions comprise a plurality of such layers 910 of conductive material, which are interposed with electrically insulating material 920 (such as said FR4 or ceramic) and are electrically combined by way of through-connections 930 (such as plated-through vias or holes with conductors inserted therethrough) to provide the electrical circuit 600.

Furthermore, for each of the plurality of phase windings, there is provided:
- a first set of electrical connections 1110 (e.g. surface-mount solder pads, or through-hole component-mounting holes) for mounting a first active device 630 (such as a transistor, either FET type or BJT type or other type);
- a second set of electrical connections 1120 (e.g. surface-mount solder pads, or through-hole component-mounting holes) for mounting a second active device 632 (such as a transistor, either FET type or BJT type or other type); and
- a connection point 612 arranged for electrical connection with the respective phase winding of the electrical machine 500 (for example, the connection point can be a solder pad or through hole for attaching a connector pin or a wire).

The first set of electrical connections 1110 comprise a power terminal 1112 for receiving current from a power supply to the first active device 630 (e.g. the power terminal 1112 can be a solder pad or through-hole for mounting a collector or drain pin of the first active device 630), and a supply terminal 1114 for supplying current to the respective phase winding from the first active device 630 (e.g. the supply terminal 1114 can be a solder pad or through-hole for mounting an emitter or source pin of the first active device 630). The first set of electrical connections 1110 optionally also comprises a first control terminal 1116 for controlling the first active device 630 (e.g. by a gate driver circuit/controller 1130).

The second set of electrical connections 1120 comprise a receiving terminal 1122 for receiving current from the respective phase winding to the second active device 632 (e.g. the receiving terminal 1122 can be a solder pad or through-hole for mounting a collector or drain pin of the second active device 632), and a ground terminal 1124 for sinking current to an electrical ground from the second active device 632 (e.g. the ground terminal 1124 can be a solder pad or through-hole for mounting an emitter or source pin of the first active device 632). The second set of electrical connections 1120 optionally also comprises a second control terminal 1126 for controlling the second active device 632 (e.g. by gate driver circuit/controller 1130).

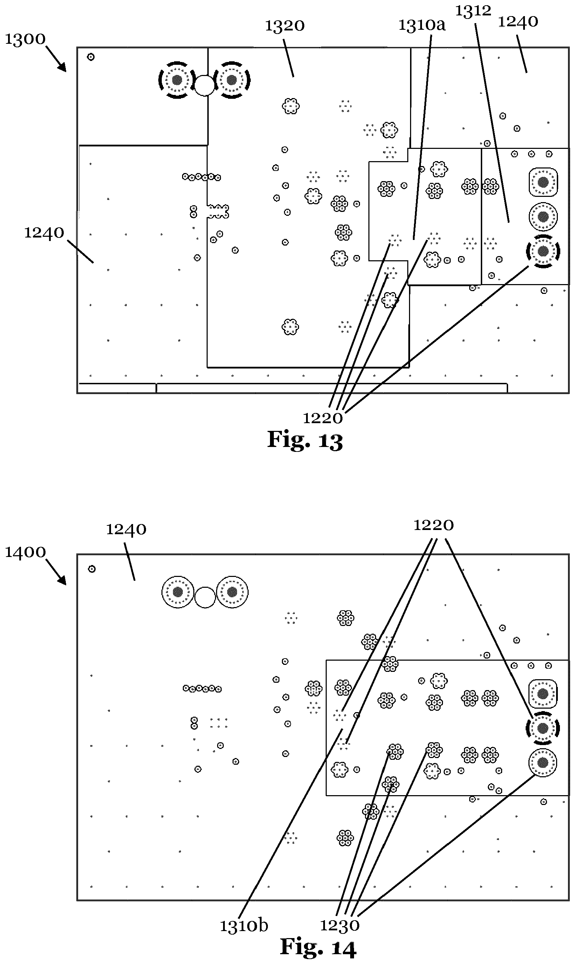

Further, for each of the plurality of phase windings there is provided a respective area of conductive material 1310a, 1310b, 1310c in at least one of the layers (for example in one or more inner layers, it being envisaged that all of the respective areas 1310a, 1310b, 1310c can be provided in the same layer, or in separate respective layers). The respective area 1310a, 1310b, 1310c forms at least part of an electrical connection between the respective connection point 612 and the respective supply terminal 1114 and the respective receiving terminal 1122. Preferably the areas 1310a, 1310b, 1310c are provided in a layer or layers that are separate from the outer layer on which the first and second electrical connections 1110, 1120 are provided, and this is implicit from the fact that the respective supply terminal 1114 and the respective receiving terminal 1122 of each phase 620 are electrically connected with their respective area 1310a, 1310b, 1310c by one or more of the through-connections 930 (e.g. printed circuit board vias). Preferably each of the phases 620 is connected with its respective area 1310a, 1310b, 1310c by more than one through-connection 930, since multiplying the number of through-connections reduces impedance, specifically resistance, thereby reducing heating effects and radiated electromagnetic emissions - for example it has been found that a star/hexagonal pattern of seven vias is compact and effective in reducing resistance between layers where it is required to carry relatively high currents e.g. in motor phase winding supply current paths. Additionally or alternatively by way of further example, clusters of 12 vias can be used to carry more current, however a greater number of vias takes up more space in each layer so there is a limit when the area available in the layers for providing the areas 1310a, 1310b, 1310c is reduced to the point where the impedance of areas 1310a, 1310b, 1310c starts to undesirably increase). As shown in Fig. 13, through-connections 930 which have a connection 1220 with the layer are shown, wherein a through-hole (which is electrically plated all the way through so as to connect through the layers) of the through-connection is evident, but the conductive land around the hole is merged with the conductive material in the layer, thereby making the connection. Conversely, as shown in Fig. 14, the corresponding through connections are pass-throughs 1230 which do not connect to that layer because as shown there is a conductive land around the through holes 930, which land is separate from and thus does not connect to the conductive material of the plane.

Preferably, the respective supply terminal 1114 and the respective receiving terminal 1122 of each phase 620 are electrically connected with their respective area 1310a, 1310b, 1310c by one or more of the through-connections 930 without using signal traces for that connection, since omitting such signal traces (e.g. by placing the through-connections 930 within the boundary of the respective terminal 1114, 1122) avoids having unshielded traces with greater length than width (which would lead to relatively high inductance) in an external layer, which traces would radiate electromagnetic signals when current was rapidly changed as in when switching between drive phases/steps.

In the optional case where the power terminal 1112 and receiving terminal 1122 are through-hole type component mounting holes, those through holes can serve as (or constitute) at least one (or more) of the through-connections 930. Preferably each of areas 1310a, 1310b, 1310c are substantially unbroken areas of conductive material, so as to reduce impedance to a minimum. Preferably but optionally, each connection point 612 is located as near as possible to its corresponding supply terminal 1114 and receiving terminal 1122, since this reduces the path length through which current must flow, and thus reduces impedance and electromagnetic emissions. Optionally all of the connection points 612 are arranged for integration into a connector 610 which can optionally be mounted to the connection points 612, the connector 610 being optionally mounted as close as possible to all of the first and second active devices 630, 632 so as to minimise conductor lengths / impedances.

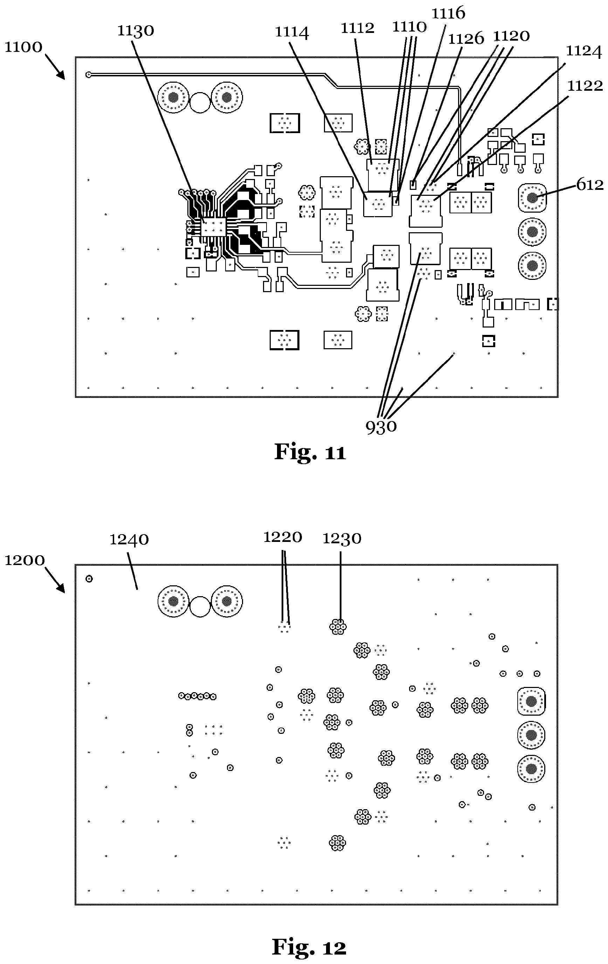

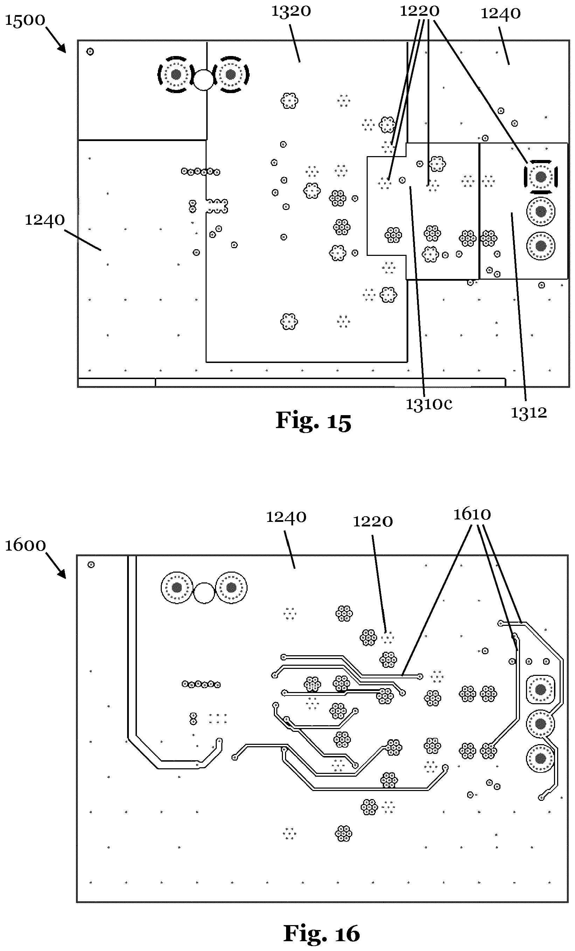

To further reduce electromagnetic emissions, the areas 1310a, 1310b, 1310c can be provided on an inner layer or on respective inner layers, between outer layers of conductive material 1240 that are connected to an electrical ground 650 (e.g. sandwiched between: an upper ground layer 1200 substantially filled with ground plane 1240 such as on layer 2 - see Fig. 12 - immediately below the top layer 1100 - see Fig. 11 - on which components are mounted; and a bottom layer 1600 - see Fig. 16 - which is either filled with ground plane 1240 or at least substantially filled with ground plane 1240 even if it may contain some other signal traces 1610). Such positioning of the areas 1310a, 1310b, 1310c between grounded layers 1200, 1600, or between layers in which an area of grounded conductive material at least overlays the areas 1310a, 1310b, 1310c, provides a low-impedance return path for any signals that may be radiated from the areas 1310a, 1310b, 1310c when motor phase current flows through them. Provision of multiple ground layers 1200 also aids with heat dissipation / cooling. Additionally, since the areas 1310a, 1310b, 1310c are in a layer that is not the top layer 1100 upon which components are mounted, there is more room to make the areas 1310a, 1310b, 1310c relatively wide compared with the lengths of their respective current path between their respective first and second active devices 630, 632 and their respective connection point 612, therefore the inductance and resistance of the areas 1310a, 1310b, 1310c is relatively low, leading to reduced electromagnetic emission. Furthermore, since in operation current flows out to one of the motor windings through one of the areas 1310a, 1310b, 1310c and back from another one of the motor windings through another of the areas 1310a, 1310b, 13010c, by having the areas in one or more layers that do not contain component mounting pads, it is possible to locate the areas 1310a, 1310b, 1310c closer to each other which further reduces electromagnetic emissions. For example, the areas 1310a, 1310b, 1310c can preferably be stacked on top of / adjacent to each other in separate layers and arranged to overlay each other as in Figs. 9 to 16. Such a scheme reduces the distance between the areas 1310a, 1310b, 1310c which carry the motor phase current, from some centimetres to merely the relatively much smaller distance between layers (less than approximately 200 micrometres), such that emitted signals cancel to at least a degree, with a corresponding reduction in electromagnetic emissions.

Distance between the layers has a direct influence on the amount of inductance in the current paths that power the phase windings. For example, in an 8-layer implementation, typical distance between layers in a common manufacturing process is about 200um, however with 10 layers this distance is reduced to about 150um. By way of example, an inductance of 14nH has been measured in the phase 1 -> phase 3 loop of the conventional layout of Fig. 7, while the improved circuit arrangement disclosed herein measured only 0.08nH, and this reduction delivers a very significant reduction in emitted electromagnetic interference. EMC measurements using this technique have an improvement margin of more than 20dB compared to traditional circuit arrangements/layouts.

The improved noise performance of the disclosed arrangement removes need for filtering components like ferrites and common mode chokes on the outputs of the transistor stages, as well as ferrites on cables, thereby reducing component/manufacturing cost. Further, using the disclosed circuit arrangement greatly reduces the risk of failing an EMC test, making hardware development more predictable. It is noted that the increased cost of using 8 or 10 layer boards instead of 6 layer boards is small compared to the reduction in cost from not needing filtering components and/or other shielding techniques such as a Faraday cage with all cables/modules shielded. Current carrying capability is also greater than in traditional designs, allowing the use of 1 oz copper instead of heavier 2 oz (or more) copper, and this reduction in copper weight requirement enables more choice of manufacturers for circuit board production, further lowering cost.

As shown in Fig. 13, in a "phase 1" layer 1300, a first area 1310a connects with first and second active devices 630, 632 of a first phase 620 by virtue of through-connections 930 which connect the area 1310a in that layer 1300 with the corresponding terminals in the top layer 1100, and the first area 1310a also connects with a current sensor 640 which connects the first area 1310a (with substantially zero resistance) to a first divided area 1312 and thus with the respective one of the connection points 612. The current sensor 640 is effectively a zero-Ohm wire link, and is not important for the way that the presently disclosed circuit arrangement reduces electromagnetic emissions, hence the first area 1310a and the first divided area 1312 can be considered to be a single area. The current sensor (provided in phases 1 and 3, but not needed in phase 2) is provided for the separate purpose of measuring the current in phases 1 and 3 (current in phase 2 can be inferred from those two measurements) such that the gate drive controller 1130 or other controller can use the current information to control the respective pairs of first/second active devices 630, 632 to deliver a desired amount of current to each motor phase winding at a desired time.

Similarly to Fig. 13, Fig. 15 shows a "phase 3" layer (or "third phase layer") 1500 in which a third area 1310c connects with first and second active devices 630, 632 of a third phase 620 by virtue of through-connections 930 which connect the area 1310c in that layer 1500 with the corresponding terminals in the top layer 1100, and the third area 1310c also connects with another current sensor 640 which connects the third area 1310c in that layer (with substantially zero resistance) to another divided area 1312, and thus with the respective one of the connection points 612.

Fig. 14 shows a "phase 2" layer (or "second phase layer") 1400, in which a second area 1310b connects with first and second active devices 630, 632 of a second phase 620 (by virtue of through-connections 930 which connect the area 1310b in that layer 1400 with the corresponding terminals in the top layer 1100), and with the respective one of the connection points 612.

Fig. 16 shows a bottom layer 1600, which conveniently can accommodate any low-power signals such as control signals between the gate driver/controller 1130 and the control gate or base terminals of the first/second active devices 630, 632, and which is otherwise advantageously filled with conductive material connected to electrical ground 650 so as to shield the inner layers carrying the areas 1310a, 1310b, 1310c. Optionally but preferably all of the layers (or portions of layers) that comprise conductive material connected to electrical ground are tied together by through-connections 930 such that all areas of ground plane 1240 are tied together with low impedance, thereby reducing the ability of any radiated signals to break through the shielding provided by said ground planes 1240.

Advantageously, as shown in Figs. 13 and 15, at least one of the plurality of layers 910 comprises at least part of a power plane 1320 that is connected to a power supply for supplying power to the respective power terminals 1112 of the first active devices 630. Preferably, the respective power terminals 1112 are provided with a plurality of the through-connections 930 within a boundary of each power terminal (e.g. 7 pcb vias in a star/hexagonal configuration), for electrically connecting the respective power terminal with the at least part of the power plane 1320. Making the connection in this way reduces electromagnetic emissions by avoiding conducting large currents across relatively narrow surface traces, and instead provides a large wide area of conductive material that is on an inner layer which thus can be shielded by a ground plane 1240. Duplicating the power plane 1320 on multiple layers further reduces resistance and this reduces resistive heating, thereby reducing cooling requirements, and reducing temperature cycling which could otherwise lead to thermal stresses / fatigue which could affect reliability.

Similarly as for the power provision to the first active devices 630, the ground provision for the second active devices 632 can advantageously be made using a plurality of through-connections 930 to a ground plane 1240 or a portion thereof. Preferably the through-connections 930 are placed within a boundary of the respective ground terminal of the second active devices 632, for electrically connecting the respective ground terminal with the at least part of the ground plane 1240, since making the connection in this way reduces electromagnetic emissions by avoiding conducting large currents across relatively narrow surface traces, and instead provides a large wide area of conductive material that is solidly coupled to electrical ground. Using a plurality of through-connections (e.g. a star/hexagon of 7 pcb vias) shares current, reducing current per through-connection, thereby reducing heating and temperature cycling which could otherwise degrade reliability.

As shown in Fig. 10, an advantageous example layer order (or "stack-up") has:
- a top layer 1100 with electrical connections 1110, 1120 for mounting components including the first and second active devices 630, 632, and optionally a connector 610 (that includes or mounts to connection points 612) and/or a gate driver/controller 1130;
- a ground layer 1200 that is substantially filled with conductive material connected to an electrical ground;
- a "phase one" layer 1300 that includes an area of conductive material 1310a forming at least a part of an electrical connection between a connection point 612 for the first motor phase winding and a first pair of first and second active devices 630, 632, and also includes a 24V (or other suitable voltage) power supply for the first active devices 630 (the power supply could be separated to another layer if desired);
- a "phase two" layer 1400 that includes an area of conductive material 1310b forming at least a part of an electrical connection between a connection point 612 for the second motor phase winding and a second pair of first and second active devices 630, 632;
- a "phase three" layer 1500 that includes an area of conductive material 1310c forming at least a part of an electrical connection between a connection point 612 for the third motor phase winding and a third pair of first and second active devices 630, 632, and (similarly to the "phase one" layer) also includes a 24V (or other suitable voltage) power supply for the first active devices 630;
- optionally a further ground layer 1200 (this can be included to provide a ground reference close by to the 24V power supply that is provided in the "phase three" layer 1500);
- optionally: a duplicate of the phase one layer 1300, followed by a duplicate of the phase two layer 1400, followed by a duplicate of the phase three layer 1500; optionally a further ground layer 1200;
- a bottom layer 1600 that is substantially filled with ground conductor, but optionally can comprise some low-power signal traces.

All of the areas 1310a, 1310b, 1310c are stacked vertically above/below each other so as to minimise impedance between them and accordingly minimise radiated power. The above disclosure aimed at brushless DC motors, but can be used for brushed DC motors. Another layer order that produces good results for a brushless motor is ground, phase 1, phase 2, phase 3, phase 1, phase 2, phase 3, ground. For a brushed motor, an 8-layer arrangement can be ground, out+, out-, out+, out-, out+, out-, ground.

At least one of the layers comprises an area of conductive material connected to a power supply (or "portion of power plane") for supplying current to the phase windings via the first active devices 630. As shown, the phase 1 layers comprise said "portion of power plane", as do the phase 3 layers (and as could the phase 2 layers, provided there was a ground layer provided next to them), and this duplication is for current sharing and resultant reduction in resistive heating, however if the driven motor phase windings are smaller and take less power then only a single portion of power plane may be necessary, and similarly it may not be necessary to duplicate the phase 1 to phase 3 layers (which is optional for current sharing / reduction of resistive heating). The optional additional ground layer 1200 ("layer 6" in Fig. 10) helps by sharing ground return current from the second active devices 632, thereby reducing resistive heating, and also aids shielding of radiated signals, plus provides an additional ground reference for signals in the assembly (such as those in/out of the gate driver /controller).

A further optional refinement can be considered in that, referring to Fig. 10, the distance between the phase 1 layer 1300 and the phase 2 layer 1400 is approximately 0.14mm (according to the example dimensions shown in Fig. 10. - other manufacturing processes may differ), while the distance between the phase 2 layer 1400 and the phase 3 layer 1500 is also approximately 0.14mm. However, the distance between the phase 3 1500 layer and the phase 1 layer 1300 is approximately double, which makes the impedance between phases 1 and 3 different to that between phases 1 and 2, and between phases 2 and 3. This can optionally be mitigated somewhat by omitting the ground layer 1200 ("layer 6" in Fig. 10) between phase 3 and the repeat of phase 1, or by altering the order of the repeated phase layers (for example by swapping "layer 8" and "layer 9" in Fig. 10). Further repeats of the phase layers can also be added so as to average out the impedance between phase layer combinations so that impedance is more consistent between phase combinations.

The repeat of the phase 1 layer ("Layer 7" in Fig. 10) also carries 3.3V power which is used by the gate driver/controller 1130, however that power supply can be placed anywhere in the layer stack (provided that there is a ground layer provided next to it in the stack), since it is low power and thus its routing is non-critical. Although the illustrated examples show 3 phases, it will be appreciated that a greater or smaller number of phases than 3 can easily be provided, and the disclosure is not limited to only 3 phases.

It is noted that reducing resistive heating is especially beneficial in the application of such a circuit arrangement in a motor driver application in a vehicle (such as a robot 204 for container handling) in a storage system 100 as described herein, because such robots are constrained in size and typically their motors and drive circuitry are enclosed in a metal chassis, e.g. to prevent contamination of stored goods by dust/grease/oil etc., and so cooling cannot easily be provided by forced air circulation and so only limited cooling tends to be available, such as by conduction from the circuit arrangement and/or motor to the chassis of the vehicle. For this, the circuit arrangement can be mounted by screws to the metal chassis of the vehicle.

Optionally, each layer is preferably filled with electrically conductive material, connected to electrical ground where possible, since this increases shielding and reduces electrical noise. Preferably, the conductive material used in the layers is copper since copper has good electrical conductivity and relatively low cost compared to other conductive metals, but the conductive material can alternatively be aluminium, silver or gold, an alloy of said metals, or one of said metals electroplated with another of said metals. Optionally, the arrangement is realised as a multi-layer printed circuit board using known pcb vias as through-connections and using known materials such as FR4 glass-fibre substrate, but alternatively the arrangement can be realised as a ceramic hybrid circuit, or using any other multi-layer planar circuit construction technology.

Optionally, the arrangement can comprise the first and second active devices 630, 632, and/or the other components such as current sensors 640 and gate driver/controller 1130, freewheel diodes 642 and reservoir/decoupling capacitors 644. Optionally, each pair of the first and second active devices 630, 632 can be duplicated for current sharing, e.g. if higher current is needed than can be provided for with a single pair of first and second active devices 630, 632 per motor phase winding. Typically the number of first active devices 630 matches the number of second active devices 632, however it is envisaged that asymmetry may be useful in certain circumstances. Typically the first and second active devices 630, 632 are both N-type devices (e.g. npn bipolar transistors or n-channel FETs), so that switching speeds of the first and second active devices 630, 632 are reasonably well matched such that one device turns off as the other turns on, without long periods where both devices are turned on which would lead to large switching losses and wasted energy as heat which would require additional cooling. The gate driver/controller 1130 in such implementations compensates for such an arrangement when it produces the voltages that are used to drive the control gate inputs of the first and second active devices 630, 632.

It will be appreciated that an automated storage and retrieval system 100 as described with reference to Figs. 1 to 5 can include one or more components (e.g. container-handling vehicles for lifting/lowering/transporting storage containers, a service vehicle for assisting with maintenance operations on the grid, and/or one or more packing stations or "ports" for operators to add or remove containers from the grid) having one or more electrical machines powered by an arrangement such as that described herein. It will also be appreciated that a vehicle such as those mentioned in the previous sentence can be provided which include one or more electrical machines powered by the herein-described arrangement of a circuit for powering one or more phase windings of an electrical machine. Furthermore, a motor powered by such an arrangement can be provided, and said motor can include such a circuit arrangement integrated into said motor. For example, the described circuit arrangement, by virtue of the vertical interconnections provided by the through-connections 930, and by locating high-current conductors on layers other than the outer layers that have component-mounting pads (which thereby provides more routing area for the high-current conductors, i.e. the areas 1310a, 1310b, 1310c), the circuit can be implemented in a more compact manner which can thus be suitable for mounting directly to a motor. Such direct mounting further reduces radiated electromagnetic energy because the connecting wires between the connection points 612 and the motor can be significantly shortened, reducing the opportunity for signals to radiate.

The reduction in electromagnetic radiation that is realised by the present disclosure advantageously reduces erroneous operation by reducing the amount of electrical noise that is radiated by the motors and motor driver electronics. This also allows closer and more compact integration of components, since the components in a vehicle (e.g. motors, controller boards) can be packed more closely together without control signals being corrupted by radiated electrical noise. Furthermore, by reducing the impedance of the high-current branches of the circuit in the described way, it has been found that the "snubber" circuits (capacitors with series resistors, connected between the phase windings so as to gracefully absorb voltage/current peaks and thereby avoid damage to the first and second active devices 630, 632) that have previously been required are no longer required, thus saving on component count/cost and saving on circuit board area. Similarly, it has been found that the disclosed techniques obviate a previous need for mechanical shielding such as metal shielding boxes, and remove the previous need to add filtering components, all of which were previously typically needed for passing radiated emission compliance tests.

It is to be understood that the above description is intended to be illustrative, and not restrictive. Many other implementations will be apparent to those of skill in the art upon reading and understanding the above description. Although the present disclosure has been described with reference to specific example implementations, it will be recognized that the disclosure is not limited to the implementations described, but can be practiced with modification and alteration within the spirit and scope of the appended claims. Accordingly, the specification and drawings are to be regarded in an illustrative sense rather than a restrictive sense. The scope of the disclosure should, therefore, be determined with reference to the appended claims, along with the full scope of equivalents to which such claims are entitled.

## Claims

1. An arrangement of an electrical circuit for powering one or more phase windings of an electrical machine of an automated storage and retrieval system, the arrangement comprising:
a plurality of layers, each layer comprising a respective pattern of electrically conductive material constituting at least part of the electrical circuit, wherein the layers are interposed with electrically insulating material, and wherein through-connections are provided between the layers through the electrically insulating material to electrically combine the layers and thereby provide the electrical circuit; and
for each of the phase windings,
a first set of electrical connections for mounting a first active device, the first set of electrical connections comprising (i) a power terminal for receiving current from a power supply to the first active device and (ii) a supply terminal for supplying current to the respective phase winding from the first active device,
a second set of electrical connections for mounting a second active device, the second set of electrical connections comprising (iii) a receiving terminal for receiving current from the respective phase winding to the second active device and (iv) a ground terminal for sinking current to an electrical ground from the second active device, and
a connection point arranged for electrical connection with the respective phase winding of the electrical machine;
wherein for each of the phase windings there is provided a respective area of conductive material in at least one of the layers, which area forms at least a part of an electrical connection between the respective connection point and the respective supply terminal and the respective receiving terminal, and
wherein the respective supply terminal and the respective receiving terminal are electrically connected with their respective area by one or more of the through-connections and without using signal traces for that connection.

2. The arrangement of claim 1, wherein each supply terminal and/or receiving terminal is provided with at least one of the through-connections within the boundary of the respective terminal, for electrically connecting the respective terminal with its respective area of conductive material.

3. The arrangement of any preceding claim, wherein each respective area of conductive material provided for the phase windings is on an inner layer between outer layers of conductive material connected to an electrical ground.

4. The arrangement of any preceding claim, wherein at least one of the plurality of layers comprises at least part of a power plane that is connected to the power supply for supplying power to the respective power terminals, and the respective power terminals are provided with a plurality of the through-connections within the boundary of the respective power terminal for electrically connecting the respective power terminal with the at least part of the power plane.

5. The arrangement of any preceding claim, wherein at least one of the plurality of layers comprises at least part of a ground plane that is connected to electrical ground for sinking current from the respective ground terminals, and the respective ground terminals are provided with a plurality of the through-connections within the boundary of the respective ground terminal for electrically connecting the respective ground terminal with the at least part of the ground plane.

6. The arrangement of any preceding claim wherein a plurality of the layers are substantially filled with conductive material that is connected to electrical ground, and wherein each of the layers that are substantially filled with conductive material that is connected to electrical ground are interconnected by a plurality of the through-connections.

7. The arrangement of claim 6, wherein at least one of the layers that are substantially filled with conductive material that is connected to electrical ground is arranged as an outermost layer of the plurality of layers, and optionally wherein both of the outermost ones of the plurality of layers are ones of the layers that are substantially filled with conductive material that is connected to electrical ground.

8. The arrangement of any preceding claim, wherein at least one of the plurality of layers is provided for carrying low-current control signals, including signals for controlling one or more of the active devices, and optionally wherein a layer that is electrically connected to electrical ground is interposed between the at least one layer that is provided for carrying low-current control signals and layers that carry electrical current between the active devices and the connection points for electrical connection with the phase windings.

9. The arrangement of any preceding claim, wherein the order or reverse order of layers includes: a succession of layers that are each associated with successive ones of the phase windings, followed by a layer substantially filled with electrically conductive material that is connected to electrical ground, and optionally then repeating the succession of layers that are each associated with successive ones of the phase windings, followed by another layer substantially filled with electrically conductive material that is connected to electrical ground.

10. The arrangement of any of claims 1 to 8, wherein the number of phases is three, and wherein the order or reverse order of layers includes: a succession of layers that are each associated with successive ones of the phase windings, followed by a repeat of the succession of layers, followed by a layer substantially filled with electrically conductive material that is connected to electrical ground.

11. The arrangement of any preceding claim, wherein the respective area for each of the phase windings is provided in a layer that is separate from that of the respective areas for the other phase windings.

12. The arrangement of any preceding claim, wherein the respective connection point for each phase winding is located as near as possible to its corresponding supply terminal and receiving terminal, and optionally: a connector comprising respective connections for each of the phase windings is mounted to the connection points, and the connector is located proximate to the first and second active devices.

13. The arrangement of any preceding claim, wherein the arrangement further comprises the first and second active devices, and optionally wherein a plurality of first active devices are provided per phase and a plurality of second active devices are provided per phase, and further optionally wherein the number of first active devices per phase equals the number of second active devices per phase.

14. An automated storage and retrieval system comprising a grid of structural members amongst which a plurality of storage spaces are provided for storing a plurality of storage containers, said automated storage and retrieval system further comprising at least one component having one or more electrical machines powered by an arrangement according to any preceding claim, wherein each at least one component is a vehicle and/or a packing station, and optionally wherein the vehicle is (i) a container handling vehicle provided for lifting, lowering and transporting storage containers or (ii) a service vehicle for assisting with maintenance operations on the grid.

15. A vehicle for an automated storage and retrieval system according to claim 14, wherein the vehicle comprises one or more electrical machines powered by an arrangement according to any of claims 1 to 13.
